(19) Europäisches Patentamt
European Patent Office
Office européen des brevets

(11) **EP 2 767 804 B1**

(12) **EUROPÄISCHE PATENTSCHRIFT**

(45) Veröffentlichungstag und Bekanntmachung des Hinweises auf die Patenterteilung:
**11.05.2016 Patentblatt 2016/19**

(51) Int Cl.:
***G01D 5/14*** *(2006.01)*     *G01R 33/07* *(2006.01)*
*G01R 33/09* *(2006.01)*

(21) Anmeldenummer: **13005477.8**

(22) Anmeldetag: **22.11.2013**

(54) **Schaltung und Messsystem**

Circuit and measuring system

Circuit et système de mesure

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.01.2013 DE 102013000431**

(43) Veröffentlichungstag der Anmeldung:
**20.08.2014 Patentblatt 2014/34**

(60) Teilanmeldung:
**15000557.7 / 2 899 510**

(73) Patentinhaber: **Micronas GmbH**
**79108 Freiburg (DE)**

(72) Erfinder:
• **Ritter, Joachim**
**79540 Lörrach (DE)**
• **Franke, Jörg**
**79117 Freiburg (DE)**

(74) Vertreter: **Koch Müller**
**Patentanwaltsgesellschaft mbH**
**Maaßstraße 32/1**
**69123 Heidelberg (DE)**

(56) Entgegenhaltungen:
**EP-A1- 1 477 772        EP-A1- 2 354 769**
**DE-A1-102007 022 196    DE-A1-102010 003 292**
**DE-A1-102010 019 508    US-A1- 2012 095 712**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft eine Schaltung und ein Messsystem.

Aus der EP 2 354 769 A1 sind ein Winkelgeber und ein Verfahren zur Bestimmung eines Winkels zwischen einer Sensoranordnung und einem Magnetfeld bekannt. Der Winkelgeber weist einen das Magnetfeld erzeugenden, bezüglich einer Drehachse in unterschiedliche Drehlagen relativ zu der Sensoranordnung verstellbaren Magneten auf. Die Sensoranordnung weist einen ersten Magnetfeldsensor zur Erfassung einer quer zur Drehachse orientierten ersten Magnetfeldkomponente und einen zweiten Magnetfeldsensor zur Erfassung einer zweiten Magnetfeldkomponente auf, die quer zu einer von der Drehachse und der ersten Magnetfeldkomponente aufgespannten Ebene angeordnet ist. Die Sensoranordnung weist einen dritten Magnetfeldsensor zur Erfassung einer in Richtung der Drehachse orientierten dritten Magnetfeldkomponente auf.

Aus der DE 10 2008 059 401 A1 ist ein Halbleiterchip und ein Verfahren zum Erzeugen von Impulsflanken bekannt, die der Bewegung eines mechanischen Teils synchron zugeordnet sind. Ein Magnetfeld wird erzeugt und mindestens zwei Messsignale werden für das Magnetfeld erfasst. Das Magnetfeld wird derart in Abhängigkeit von der Bewegung des mechanischen Teils verändert, dass die Messsignale zueinander phasenverschoben moduliert werden. Ein erstes Messsignal wird mit einem ersten Referenzwert verglichen. Ein zweites Messsignal wird mit einem zweiten Referenzwert verglichen. Der Betrag des ersten Messsignals wird mit dem Betrag des zweiten Messsignals verglichen. Eine Impulsflanke wird erzeugt, wenn mindestens einer dieser Vergleiche eine Übereinstimmung ergibt oder das Ergebnis des betreffenden Vergleichs sein Vorzeichen ändert. Aus der DE 10 2010 0195 08 A1, der US 2012 / 095712 A1, der DE 10 2007 022 196 A1 und der DE 10 2010 002 292 A1 sind weitere gattungsbildende Schaltungen und Messsysteme bekannt. Des Weiteren ist auch aus der EP 1 477 772 A1 eine Magnetfeldsensoranordnung bekannt.

Aus der EP 1 111 392 A1 ist ein Erfassen der Drehzahl und Winkelstellung eines rotierenden Rades mit anpassbarer Schaltschwelle zur Driftkompensation bekannt. Das Erfassen der Drehzahl und der

Winkelstellung eines Rades erfolgt mittels eines berührungslos das Rad abtastenden Sensors, der eine Impulsfolge erzeugt. Die Amplitude der Impulse wird in einem Vergleicher mit einer variablen Schaltschwelle verglichen. Die Schaltschwelle wird so angepasst, dass der Betrag der Differenz zwischen den Amplituden der Impulse und der Schaltschwelle einen vorgebbaren Höchstwert nicht überschreitet.

Aus ELEKTRONIK PRAXIS, Nr. 18, 17. Sept. 2008, Seite 22, J. Quasdorf ist ein optisches Nonius-System bekannt. Die Interpolation analoger Sinussignale ist eine Auswertefunktion bei Positionssensoren. Mit einem speziellen Verfahren ist es möglich, mehrere Messskalen auszuwerten und zu einem Positionswert zu kombinieren. Damit sind Messsysteme möglich, die eine hohe integrale Genauigkeit oder sehr hohe Auflösungen mit guter differenzieller Genauigkeit bieten. Für die Abtastung genügt ein kleiner optischer Sensor.

Aus der EP 1 503 182 B1 ist ein Drehwinkelsensor bekannt, wie dieser in der Fig. 1 dargestellt ist. Der Drehwinkelsensor weist eine drehbare Welle, einen mit der drehbaren Welle gekoppelten Magneten und ein magnetempfindliches Sensorelement auf. Das Sensorelement erzeugt in Abhängigkeit vom relativen Drehwinkel zwischen dem Magneten und dem Sensor ein sinusförmiges und ein kosinusförmiges Ausgangssignal. Der Drehwinkelsensor weist eine Auswerteeinheit auf, die aus den Ausgangssignalen ein dem Drehwinkel entsprechendes Signal erzeugt. Die Welle ist längs einer Führungsbahn bei ihrer Drehung um ihre Achse zusätzlich linear parallel zu ihrer Achse verschieblich geführt, so dass sich der Abstand zwischen Magnet und Sensor entsprechend einer Steigung der Führungsbahn verändert. Die Auswerteeinheit ermittelt aus Ausgangssignalen des Sensorelementes ein Signal, aus welchem der Abstand zwischen dem Sensorelement und dem Magneten und damit die Anzahl der vollen Umdrehungen der Welle ermittelbar sind. Aus den sinusförmigen und kosinusförmigen Ausgangssignalen wird ein Feinsignal innerhalb einer vollen Umdrehung ermittelt und dieses Feinsignal wird zu dem Wert der vollen Umdrehung multipliziert mit 360° hinzuaddiert.

Vor diesem Hintergrund ist es die Aufgabe der vorliegenden Erfindung, ein Messsystem anzugeben, das den Stand der Technik weiterbildet.

Diese Aufgabe wird durch ein Messsystem mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist ein Messsystem mit einer Magnetfeldsensoranordnung und mit einem rotatorisch beweglichen Geber und mit einer Auswertungsschaltung vorgesehen.

Die Magnetfeldsensoranordnung weist einen in einem Halbleiterchip integrierten ersten Magnetfeldsensor zur Messung einer ersten Komponente eines Magnetfeldes in einer ersten Raumrichtung und einen im Halbleiterchip integrierten zweiten Magnetfeldsensor zur Messung einer zweiten Komponente des Magnetfeldes in einer zweiten Raumrichtung auf.

Der rotatorisch bewegliche Geber weist eine Mehrzahl von Magneten auf, die mit jeder Umdrehung des Gebers mittels einer Mehrzahl von Polpaaren eine drehwinkelabhängige erste Magnetfeldänderung mit einer ersten Periodizität in der Magnetfeldsensoranordnung erzeugen.

An die Auswertungsschaltung sind der erste Magnetfeldsensor und der zweite Magnetfeldsensor angeschlossen.

Die Auswertungsschaltung ist eingerichtet, zur Erzeugung eines ersten Signals mit der ersten Periodizität aus einem ersten Messsignal des ersten Magnetfeldsensors und einem zweiten Messsignal des zweiten Magnetfeldsensors entsprechend einer Arcustangens-Funktion.

Der rotatorische Geber ist ausgebildet, eine drehwinkelabhängige zweite Magnetfeldänderung mit einer zweiten Periodizität in der Magnetfeldsensoranordnung zu erzeugen. Eine Periode der zweiten Periodizität entspricht einer Umdrehung des Gebers.

Die Auswertungsschaltung ist eingerichtet, ein zweites Signal mit der zweiten Periodizität aus dem ersten Messsignal des ersten Magnetfeldsensors und dem zweiten Messsignal des zweiten Magnetfeldsensors entsprechend einer Betragsfunktion zu erzeugen.

Die Auswertungsschaltung weist eine Logik auf, die eingerichtet ist, einen Drehwinkel des Gebers basierend auf dem ersten Signal und dem zweiten Signal zu bestimmen.

Die Aufgabe wird weiterhin durch ein Messsystem mit den Merkmalen des unabhängigen Anspruchs 2 gelöst. Vorteilhafte Weiterbildungen sind Gegenstand von abhängigen Ansprüchen und in der Beschreibung enthalten.

Demzufolge ist ein Messsystem mit einer Magnetfeldsensoranordnung und mit einem entlang einer Bahn beweglichen Geber und mit einer Auswertungsschaltung vorgesehen.

Die Magnetfeldsensoranordnung weist einen in einem Halbeiterchip integrierten ersten Magnetfeldsensor zur Messung einer ersten Komponente eines Magnetfeldes in einer ersten Raumrichtung und einen im Halbeiterchip integrierten zweiten Magnetfeldsensor zur Messung einer zweiten Komponente des Magnetfeldes in einer zweiten Raumrichtung auf.

Der entlang der Bahn bewegliche Geber weist eine Mehrzahl von Magneten aufweist, die mit einer Bewegung des Gebers entlang der Bahn mittels einer Mehrzahl von Polpaaren eine wegabhängige erste Magnetfeldänderung mit einer ersten Periodizität in der Magnetfeldsensoranordnung erzeugen.

An die Auswertungsschaltung sind der erste Magnetfeldsensor und der zweite Magnetfeldsensor angeschlossen.

Die Auswertungsschaltung ist eingerichtet, zur Erzeugung eines ersten Signals mit der ersten Periodizität aus einem ersten Messsignal des ersten Magnetfeldsensors und einem zweiten Messsignal des zweiten Magnetfeldsensors entsprechend einer Arcustangens-Funktion.

Der Geber ist ausgebildet, eine wegabhängige zweite Magnetfeldänderung mit einer zweiten Periodizität in der Magnetfeldsensoranordnung zu erzeugen. Die zweite Periodizität ist größer als die erste Periodizität.

Die Auswertungsschaltung ist eingerichtet, ein zweites Signal mit der zweiten Periodizität aus dem ersten Messsignal des ersten Magnetfeldsensors und dem zweiten Messsignal des zweiten Magnetfetdsensors entsprechend einer Betragsfunktion zu erzeugen.

Die Auswertungsschaltung weist eine Logik auf, die eingerichtet ist, eine Position des Gebers basierend auf dem ersten Signal und dem zweiten Signal zu bestimmen.

Die Aufgabe wird weiterhin durch ein Messsystem mit den Merkmalen des unabhängigen Anspruchs 3 gelöst. Vorteilhafte Weiterbildungen sind Gegenstand von abhängigen Ansprüchen und in der Beschreibung enthalten.

Demzufolge ist ein Messsystem mit einer Magnetfeldsensoranordnung und mit einem rotatorisch beweglichen Geber und mit einer Auswertungsschaltung vorgesehen.

Die Magnetfeldsensoranordnung weist einen in einem Halbeiterchip integrierten ersten Magnetfeldsensor zur Messung einer ersten Komponente eines Magnetfeldes in einer ersten Raumrichtung und einen im Halbeiterchip integrierten zweiten Magnetfeldsensor zur Messung einer zweiten Komponente des Magnetfeldes in einer zweiten Raumrichtung und einen Magneten auf.

Der rotatorisch bewegliche Geber weist eine Mehrzahl von Zähnen auf. Ein Material der Zähne beeinflusst das Magnetfeld des Magneten.

Die Zähne des Gebers sind ausgebildet, mit jeder Umdrehung des Gebers eine drehwinkelabhängige erste Magnetfeldänderung mit einer ersten Periodizität in der Magnetfeldsensoranordnung zu erzeugen.

An die Auswertungsschaltung sind der erste Magnetfeldsensor und der zweite Magnetfeldsensor angeschlossen.

Die Auswertungsschaltung ist eingerichtet, zur Erzeugung eines ersten Signals mit der ersten Periodizität aus einem ersten Messsignal des ersten Magnetfeldsensors und einem zweiten Messsignal des zweiten Magnetfeldsensors entsprechend einer Arcustangens-Funktion.

Der Geber ist ausgebildet, eine drehwinkelabhängige zweite Magnetfeldänderung mit einer zweiten Periodizität in der Magnetfeldsensoranordnung zu erzeugen. Eine Periode der zweiten Periodizität entspricht einer Umdrehung des Gebers.

Die Auswertungsschaltung ist eingerichtet, ein zweites Signal mit der zweiten Periodizität aus dem ersten Messsignal des ersten Magnetfeldsensors und dem zweiten Messsignal des zweiten Magnetfeldsensors entsprechend einer Betragsfunktion zu erzeugen.

Die Auswertungsschaltung weist eine Logik auf, die eingerichtet ist, einen Drehwinkel des Gebers basierend auf dem ersten Signal und dem zweiten Signal zu bestimmen.

Die Aufgabe wird weiterhin durch ein Messsystem mit den Merkmalen des unabhängigen Anspruchs 4 gelöst. Vorteilhafte Weiterbildungen sind Gegenstand von abhängigen Ansprüchen und in der Beschreibung enthalten.

Demzufolge ist ein Messsystem mit einer Magnetfeldsensoranordnung und mit einem entlang einer Bahn beweglichen Geber und mit einer Auswertungsschaltung vorgesehen.

Die Magnetfeldsensoranordnung weist einen in einem Halbeiterchip integrierten ersten Magnetfeldsensor zur Messung einer ersten Komponente eines Magnetfeldes in einer ersten Raumrichtung und einen im Halbeiterchip integrierten zweiten Magnetfeldsensor zur Messung einer zweiten Komponente des Magnetfeldes in einer zweiten Raumrichtung und einen Magneten auf.

Der entlang der Bahn bewegliche Geber weist eine Mehrzahl von Zähnen auf. Ein Material der Zähne beeinflusst das Magnetfeld des Magneten.

Die Zähne des Gebers sind ausgebildet, bei einer Bewegung des Gebers entlang der Bahn eine wegabhängige erste Änderung des Magnetfelds mit einer ersten Periodizität in der Magnetfeldsensoranordnung zu erzeugen.

An die Auswertungsschaltung sind der erste Magnetfeldsensor und der zweite Magnetfeldsensor angeschlossen.

Die Auswertungsschaltung ist eingerichtet, zur Erzeugung eines ersten Signals mit der ersten Periodizität aus einem ersten Messsignal des ersten Magnetfeldsensors und einem zweiten Messsignal des zweiten Magnetfeldsensors entsprechend einer Arcustangens-Funktion.

Der Geber ist ausgebildet, eine wegabhängige zweite Änderung des Magnetfelds mit einer zweiten Periodizität in der Magnetfeldsensoranordnung zu erzeugen. Die zweite Periodizität ist größer als die erste Periodizität.

Die Auswertungsschaltung ist eingerichtet, ein zweites Signal mit der zweiten Periodizität aus dem ersten Messsignal des ersten Magnetfeldsensors und dem zweiten Messsignal des zweiten Magnetfeldsensors entsprechend einer Betragsfunktion zu erzeugen.

Die Auswertungsschaltung weist eine Logik auf, die eingerichtet ist, eine Position des Gebers basierend auf dem ersten Signal und dem zweiten Signal zu bestimmen.

Durch die zuvor erläuterten Lösungen der Aufgabe durch die Merkmale des Ansprüche 1 bis 4 wird eine Vielzahl von Vorteilen erzielt. Durch die Mehrzahl der Magneten des Gebers, bzw. durch die Mehrzahl der Zähne des Gebers kann eine hohe Auflösung der Position erzielt werden. In Synergie kann zudem die Position innerhalb der Umdrehung des Gebers aus den gleichen Messsignalen eindeutig gewonnen werden. Ein zusätzlicher Sensor ist nicht erforderlich.

Gemäß einer vorteilhaften Ausgestaltung lautet die Arkustangens-Funktion:

$$D = \arctan (A/B) \tag{1}$$

D ist das erste Signal, A ist das erste Messsignal und B ist das zweite Messsignal.

Gemäß einer vorteilhaften Ausgestaltung lautet die Betrags-Funktion:

$$C = |A| + |B| \tag{2}$$

C ist das zweite Signal, A ist das erste Messsignal und B ist das zweite Messsignal. Alternativ können auch eine andere Arkustangens-Funktion oder eine andere Betrags-Funktion vorgesehen sein.

In einer vorteilhaften Ausgestaltung ist vorgesehen, dass eine Periode der zweiten Periodizität einer Wegstrecke zwischen Endpunkten der Bahn entspricht. Beispielsweise ändert sich das zweite Signal proportional zur zurückgelegten Strecke zwischen den beiden Endpunkten.

Gemäß einer vorteilhaften Weiterbildung ist der Geber ausgebildet, die zweite Magnetfeldänderung mittels einer Änderung einer Luftspaltbreite zwischen dem Geber und der Magnetfeldsensoranordnung zu erzeugen. Alternativ kann vorgesehen sein, dass zumindest ein Magnet des Gebers eine von den deren Magneten abweichende Magnetisierung aufweist.

In einer anderen vorteilhaften Weiterbildung ist die Logik eingerichtet, ein Ergebnis der Betragsfunktion mit einer Anzahl von Schwellwerten zu vergleichen. Wird das Ergebnis der Betragsfunktion beispielsweise mit einem einzigen Schwellwert verglichen, kann eine Nullstellung des Gebers ermittelt werden. Eine größere Anzahl von Schwellwerten, wie diese beispielsweise in einem Analog-Digital-Umsetzer mit mehreren Bits verwendet wird, ermöglicht eine Positionsbereichsbestimmung des Gebers. Die Positionsbereichsbestimmung weist dabei vorzugsweise eine gröbere Auflösung als das erste Signal auf.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen

Fig. 1 ein Messsystem nach dem Stand der Technik,

Fig. 2 eine schematische Ansicht eines Ausführungsbeispiels eines Messsystems,

Fig. 3 eine schematische Ansicht eines weiteren Ausführungsbeispiels eines Messsystems,

Fig. 4 eine schematische Ansicht eines weiteren Ausführungsbeispiels eines Messsystems,

Fig. 5 eine schematische Ansicht eines weiteren Ausführungsbeispiels eines Messsystems,

Fig. 6 eine schematische Ansicht eines weiteren Ausführungsbeispiels eines Messsystems,

Fig. 7 ein schematisches Diagramm mit Messsignalen eines weiteren Ausführungsbeispiels eines Messsystems,

Fig. 8 ein schematisches Diagramm eines Verlaufs eines Magnetfeldvektors eines weiteren Ausführungsbeispiels eines Messsystems,

Fig. 9 ein schematisches Diagramm eines Verlaufs eines Magnetfeldvektors eines weiteren Ausführungsbeispiels eines Messsystems,

Fig. 10 ein schematischer Blockschaltplan eines weiteren Ausführungsbeispiels eines Messsystems, und

Fig. 11 ein schematisches Diagramm mit Messsignalen eines weiteren Ausführungsbeispiels eines Messsystems.

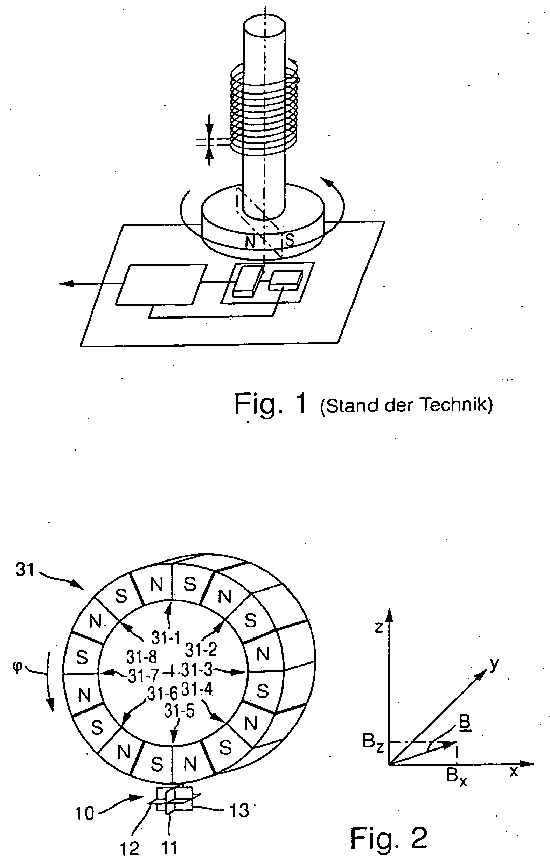

In Fig. 2 ist ein Messsystem schematisch dargestellt. Das Messsystem weist eine Magnetfeldsensoranordnung 10 auf. In der Magnetfeldsensoranordnung 10 wird ein Magnetfeldvektor $\underline{B}$ bestimmt. Der Magnetfeldvektor $\underline{B}$ ist in Fig. 2 in einem Koordinatensystem mit den Raumrichtungen x, y und z schematisch dargestellt. Für eine einfachere Erfassbarkeit der Darstellung ist der Ursprung des Koordinatensystems von der Mitte der Magnetfeldsensoranordnung 10 versetzt dargestellt. Ebenfalls sind im Koordinatensystem Komponenten $B_x$, $B_z$ des Magnetfeldvektor $\underline{B}$ dargestellt.

Die Magnetfeldsensoranordnung 10 weist einen in einem Halbeiterchip integrierten ersten Magnetfeldsensor 11 zur Messung einer ersten Komponente $B_x$ des Magnetfeldvektors $\underline{B}$ des Magnetfeldes in einer ersten Raumrichtung x auf. Die Magnetfeldsensoranordnung 10 weist einen im Halbeiterchip integrierten zweiten Magnetfeldsensor 12 zur Messung einer zweiten Komponente $B_z$ des Magnetfeldvektors $\underline{B}$ des Magnetfeldes in einer zweiten Raumrichtung z auf. Zudem weist die Magnetfeldsensoranordnung 10 einen im Halbeiterchip integrierten dritten Magnetfeldsensor 13 zur Messung einer dritten Komponente By des Magnetfeldvektors $\underline{B}$ des Magnetfeldes in einer dritten Raumrichtung y auf.

Das Messsystem der Fig. 2 weist einen rotatorisch beweglichen Geber 31 in Form eines Polrades auf. Das Polrad 31 weist eine Anzahl von Magneten aufweist, die mit jeder Umdrehung des Polrades 31 mittels einer Mehrzahl von Polpaaren 31-1, 31-2, 31-3, 31-4, 31-5, 31-6, 31-7, 31-8 eine drehwinkelabhängige erste Magnetfeldänderung mit einer ersten Periodizität T1 in der Magnetfeldsensoranordnung 10 erzeugen. Das Polrad 31 als rotatorischer Geber 31 ist mit acht Polpaaren 31-1, 31-2, 31-3, 31-4, 31-5, 31-6, 31-7, 31-8 ausgebildet, eine drehwinkelabhängige zweite Magnetfeldänderung mit einer zweiten Periodizität T2 in der Magnetfeldsensoranordnung 10 zu erzeugen. Eine Periode der zweiten Periodizität T2 entspricht einer Umdrehung des Polrades 31. Somit wiederholt sich die zweite Magnetfeldänderung bei jeder Umdrehung des Polrades 31. Dabei erzeugen die Polpaare 31-1, 31-2, 31-3, 31-4, 31-5, 31-6, 31-7, 31-8 in der Magnetfeldsensoranordnung 10 den Magnetfeldvektor B mit unterschiedlichen Längen. Die zweite Magnetfeldänderung ist somit im Ausführungsbeispiel der Fig. 2 eine Magnetfeld-Amplituden-Modulation, die die erste Magnetfeldänderung überlagert. Mit der zweiten Magnetfeldänderung steigt beispielsweise die Länge des Magnetfeldvektors B vom ersten Polpaar 31-1 bis zum letzten Polpaar 31-8 in einer Drehrichtung stetig an. In diesem Fall weist die Amplitudenmodulation zur zweiten Magnetfeldänderung eine Sägezahnform auf.

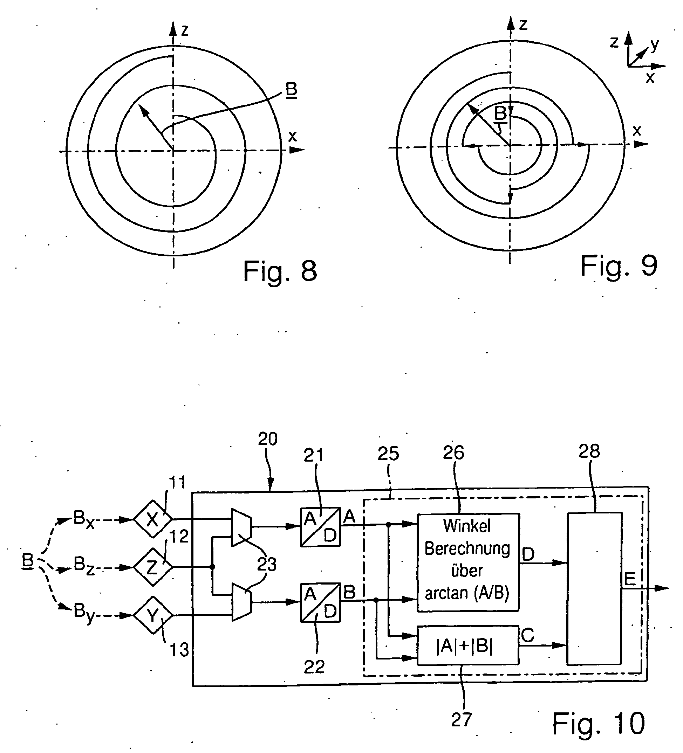

In Fig. 10 ist eine Auswertungsschaltung 20 des Messsystems gezeigt. An die Auswertungsschaltung 20 sind der erste Magnetfeldsensor 11 und der zweite Magnetfeldsensor 12 und der dritte Magnetfeldsensor 13 angeschlossen. Die Auswertungsschaltung 20 weist einen ersten Analog-Digital-Umsetzer 21 und einen zweiten Analog-Digital-Umsetzer 22 auf. Mittels der Multiplexer 23 können die analogen Ausgangssignale der Magnetfeldsensoren 11, 12, 13 auf die Eingänge der Analog-Digital-Umsetzer 21, 22 geschaltet werden. Je nach Lage der Auswertungsschaltung 20 können so die für die Messaufgabe benötigten Magnetfeldsensoren 11, 12, 13 ausgewählt werden. Alternativ zum Ausführungsbeispiel der Fig. 10 kann für jeden Magnetfeldsensor 11, 12, 13 ein Analog-Digital-Umsetzer vorgesehen sein. In diesem Fall würden auf der digitalen Seite die Signale ausgewählt werden und die Multiplexer 23 könnten entfallen. Alternativ könnte auch ein einziger schneller Analog-Digital-Umsetzer verwendet werden, und die Analogsignale der Magnetfeldsensoren 11, 12, 13 werden in schneller Folge zyklisch auf den Eingang des einzigen Analog-Digital-Umsetzers mittels eines Multiplexers geschaltet.

Im Folgenden soll für das Ausführungsbeispiel der Fig. 10 angekommen werden, dass der erste Magnetfeldsensor 11 auf den ersten Analog-Digital-Umsetzer 21 und der zweite Magnetfeldsensor 12 auf den zweiten Analog-Digital-Umsetzer 22 geschaltet sind.

Die Auswertungsschaltung 20 weist eine Logik 25 auf, wobei in Fig. 10 mehrere Funktionsblöcke 26, 27, 28 der Logik 25 schematisch dargestellt sind. Die Funktionsblöcke 26, 27, 28 sind beispielsweise durch Software oder spezielle Hardware realisiert. Die Auswertungsschaltung 20 ist mittels des Funktionsblocks 26 zur Erzeugung eines ersten Signals D mit der ersten Periodizität aus einem ersten Messsignal A des ersten Magnetfeldsensors 11 und einem zweiten Messsignal B des zweiten Magnetfeldsensors 12 entsprechend einer Arcustangens-Funktion eingerichtet:

$$D = \arctan (A/B) \qquad\qquad\qquad (1)$$

Die Auswertungsschaltung 20 ist mittels des Funktionsblocks 27 zur Erzeugung eines zweiten Signals C mit der zweiten Periodizität aus dem ersten Messsignal A des ersten Magnetfeldsensors 11 und dem zweiten Messsignal B des zweiten Magnetfeldsensors 12 entsprechend einer Betragsfunktion eingerichtet:

$$C = |A| + |B| \qquad\qquad\qquad (2)$$

Die Logik 25 ist mittels des Funktionsblocks 28 eingerichtet, einen Drehwinkel $\varphi$ des Polrades 31 basierend auf dem ersten Signal D und dem zweiten Signal C zu bestimmen.

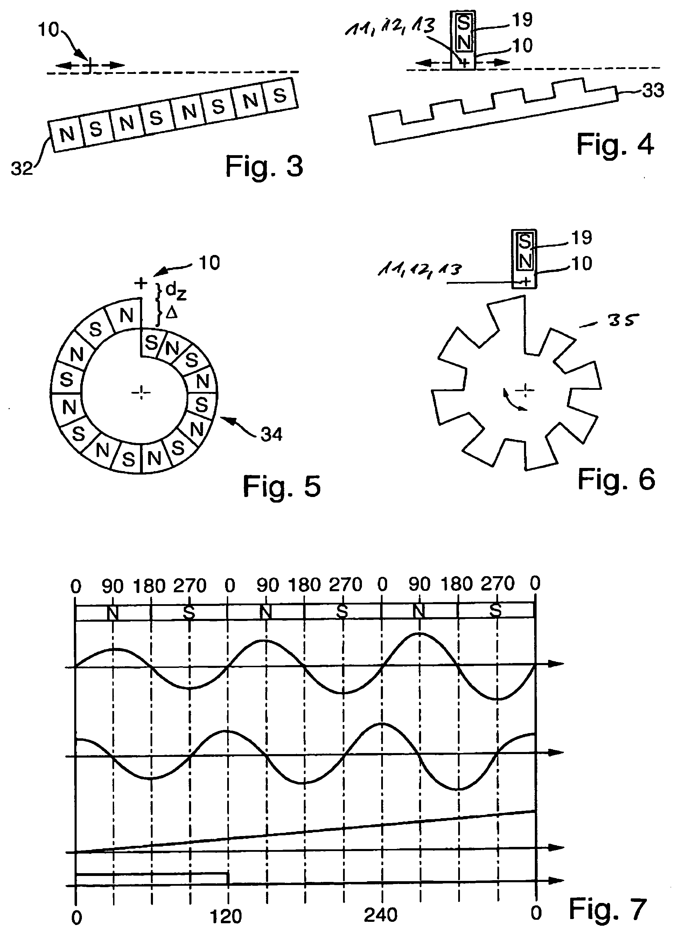

Ein Verlauf der Signale A, B und C ist in Fig. 7 für ein anderes Ausführungsbeispiels mit drei Polpaaren schematisch dargestellt. Das erste Messsignal A ist gegenüber dem zweiten Messsignal B um 90° phasenverschoben (Sinus und Kosinus). Das zweite durch die Betragsfunktion gewonnene Signal C weist eine Sägezahnform auf. Im Ausführungsbeispiel der Fig. 7 ist die Periode der zweiten Periodizität T2 dreimal so groß wie die Periode der ersten Periodizität T1. Die Arcustangensfunktion stellt die Grundfrequenz (Polpaar) dar. Die Betragsfunktion erlaubt das Unterscheiden mehrerer Polpaare untereinander.

In Fig. 7 ist ein weiteres Ausführungsbeispiel schematisch dargestellt, indem keine Sägezahnsignalform, sondern eine Amplitudenerhöhung für genau ein Polpaar nach Art einer Rechteckfunktion gemäß dem Signal C' erzeugt wird. Das Polpaar mit der Amplitudenerhöhung kann als Nullstelle ausgewertet werden, wobei die anderen Drehwinkel durch Zählen der Polpaare nach der Nullstelle ermittelt werden. Diese Ausführungsform ist aufgrund des Digitalcharakters der Rechteckform besonders robust gegenüber Störungen, lässt eine genaue Drehwinkelbestimmung erst nach Passieren der Nullstelle zu.

Die Ausführungsbeispiele der Figuren 3, 4, 5 und 6 zeigen unterschiedliche Messsysteme, die ebenfalls eine Änderung der Länge des Magnetfeldvektors B̲ bewirken.

Im Ausführungsbeispiel der Fig. 3 führt die Magnetfeldsensoranordnung 10 entlang der gestrichelten Linie eine Relativbewegung zum Geber 32 aus. Der Geber 32 weist wiederum eine Mehrzahl von Polpaaren auf. Demzufolge ist der Geber 32 einer geraden Bahn beweglich. Die Magnete des Gebers 32 erzeugen mit einer Bewegung des Gebers 32 entlang der Bahn mittels der Polpaare eine wegabhängige erste Magnetfeldänderung mit einer ersten Periodizität in der Magnetfeldsensoranordnung 10. Dabei sind die Magnete des Gebers 32 derart angeordnet, dass in Abhängigkeit von der Position des Gebers 32 ein Abstand zwischen den Magneten des Gebers 32 und der Magnetfeldsensoranordnung 10 zur Erzeugung der zweiten Periodizität verändert wird. Dabei nimmt mit Verringerung des Abstands die Länge des Magnetfeldvektors zu.

Im Ausführungsbeispiel der Fig. 4 weist der Geber 33 eine Mehrzahl von Zähnen auf. Die Zähne beeinflussen ein Magnetfeld in einer Magnetfeldsensoranordnung 10. Die Magnetfeldsensoranordnung 10 weist hierzu einen Magneten 19 auf. Der Geber 33 ist entlang einer Bahn relativ zur Magnetfeldsensoranordnung 10 beweglich, so dass die Magnetfeldsensoranordnung 10 eine Relativbewegung entlang der gestrichelten Linie ausführt. Die Zähne des Gebers 33 sind ausgebildet, bei einer Bewegung des Gebers 33 entlang der Bahn eine wegabhängige erste Änderung des Magnetfelds mit einer ersten Periodizität in der Magnetfeldsensoranordnung 10 zu erzeugen. Dabei sind die Zähne des Gebers 33 derart angeordnet, dass in Abhängigkeit von der Bewegung des Gebers 33 ein Abstand zwischen den Spitzen der Zähne des Gebers 33 und der Magnetfeldsensoranordnung 10 zur Erzeugung einer zweiten Periodizität verändert wird. Dabei nimmt mit Verringerung des Abstands die Länge des Magnetfeldvektors zu.

Im Ausführungsbeispiel der Fig. 5 ist der Geber 34 ein Polrad 34. Das Polrad 34 weist eine Mehrzahl von Magneten zur Bildung von Polpaaren auf. Die Magnete des Gebers 34 erzeugen mit einer Rotation des Gebers 34 mittels der Polpaare eine wegabhängige erste Magnetfeldänderung mit einer ersten Periodizität in der Magnetfeldsensoranordnung 10. Dabei sind die Magnete des Gebers 34 derart angeordnet, dass in Abhängigkeit vom Drehwinkel φ des Gebers 34 ein Abstand zwischen den Magneten des Gebers 34 und der Magnetfeldsensoranordnung 10 verändert wird. Dabei nimmt mit Verringerung des Abstands die Länge des Magnetfeldvektors zu.

Im Ausführungsbeispiel der Fig. 6 ist der Geber 35 ein Zahnrad 35 mit einer Mehrzahl von Zähnen. Die Zähne beeinflussen ein Magnetfeld in einer Magnetfeldsensoranordnung 10. Die Magnetfeldsensoranordnung 10 weist hierzu einen Magneten 19 auf. Der Geber 35 ist rotatorische beweglich. Dabei sind die Zähne des Gebers 35 derart ausgebildet, dass in Abhängigkeit vom Drehwinkel φ des Gebers 35 ein Abstand zwischen den Spitzen der Zähne des Gebers 35 und der Magnetfeldsensoranordnung 10 zur Erzeugung der zweiten Periodizität verändert wird. Dabei nimmt mit Verringerung des Abstands die Länge des Magnetfeldvektors zu.

In den Ausführungsbeispielen der Figuren 3 bis 6 ist eine Relativbewegung zwischen Geber 35 und Magnetfeldsensoranordnung 10 möglich. Dabei kann die Magnetfeldsensoranordnung 10 ortfest sein und der Geber 35 bewegt werden. Ebenfalls ist es möglich, den Geber 35 ortsfest anzuordnen und die Magnetfeldsensoranordnung 10 zu bewegen. Auch ist es möglich, sowohl Geber 35 als auch die Magnetfeldsensoranordnung 10 zu bewegen.

Ein weiteres Ausführungsbeispiel ist in Fig. 8 schematisch dargestellt. Fig. 8 zeigt einen Magnetfeldvektor B, sowie dessen Verlauf in Abhängigkeit von einer Bewegung eines Gebers eines Messsystems. Jede mechanische Umdrehung erzeugt einen im Urzeigersinn zunehmenden Betrag der Magnetfeldstärke, welcher aus einem sinusförmigen Magnetfeld durch zwei um 90° versetzten Magnetfeldsensoren für ein Sinusmesssignal und ein Kosinusmesssignal erfasst und berechnet wird. Die magnetische Amplitude nimmt im Uhrzeigesinn zu, so dass mehrere magnetische Polpaare innerhalb einer Umdrehung und über beide Umdrehungen hinweg Polpaare voneinander unterschieden werden können. In dieser Darstellung entspricht die Länge des Pfeils B dem Betrag und die Richtung dem Winkel des Magnetfeldes.

Mit nur zwei Raumrichtungen x, y - ohne Modulation in die weitere Raumrichtung z - können mehrere Umdrehungen oder mehrere geradlinig aufeinander folgende Polpaare sicher unterschieden werden, solange keine Kreuzung der durch den Verlauf des Magnetvektors B beschriebenen Linie stattfindet. In der Fig. 9 ist ein Ausführungsbeispiel mit einer derartigen Kreuzung der durch den Verlauf des Magnetvektors B beschriebenen Linie dargestellt. Kontinuierliche Rotation lässt beim Kreuzen Mehrdeutigkeiten entstehen. eine Instanz, welche die Historie kennt, kann diese Mehrdeutigkeiten auslösen. Der Betrag kann gemäß Fig. 8 sich kontinuierlich ändern was zu einer Spiralform führt. Ändert sich der Betrag gemäß Fig. 9 sprunghaft, führt dies zu einer gestuften Spiralform. In den beiden Ausführungsbeispielen der Figuren 8 und 9 können zumindest zwei Polpaare innerhalb jeder Umdrehung unterschieden werden.

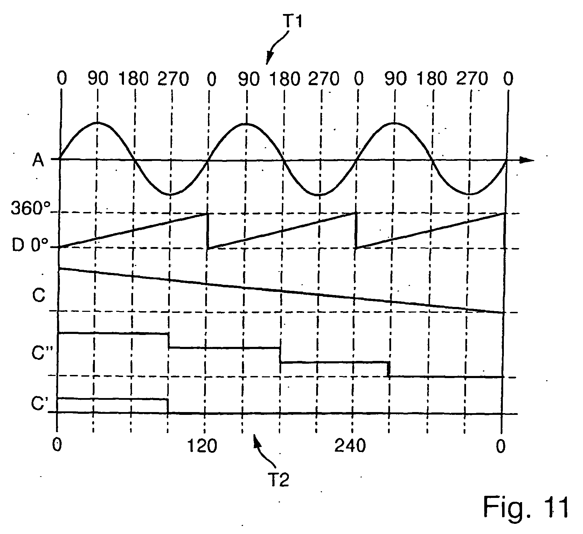

Fig. 11 zeigt ein Ausführungsbeispiel mit drei Polpaaren in Form eines Diagramms. Die Signale beziehen sich dabei auf die Fig. 10. Zuoberst ist ein durch die Polpaare erzeugtes Sinussignal A dargestellt. Unterhalb ist das Signal D des Ausgangswertes der Arcustangens-Funktion dargestellt. Das Betragssignal C ist als fallendes Sägenzahnsignal gebildet. Zusätzlich zeigt Fig. 11 ein Signal C" einer Betragsfunktion, wobei sich der Betrag stufenförmig in vier Stufen ändert. Zusätzlich kann mittels eines Vergleichers eine Nullstellung anhand des Signals C' erfolgen.

Die Erfindung ist nicht auf die dargestellten Ausgestaltungsvarianten der Figuren 2 bis 11 beschränkt. Beispielsweise ist es möglich, andere Betragsfunktionen zu verwenden. Auch ist es möglich, andere Geber mit einer komplexeren Anordnung von Magneten vorzusehen. Die Funktionalität des Messsystems gemäß den Figuren 2 und 10 kann besonders vorteilhaft für ein Verstellsystem oder Antriebssystem verwendet werden.

Bezugszeichenliste

| | |
|---|---|
| 10 | Magnetfeldsensoranordnung |
| 11, 12, 13 | Magnetfeldsensor |
| 19 | Magnet |
| 20 | Auswertungsschaltung |
| 21, 22 | Analog-Digital-Umsetzer |
| 23 | Multiplexer |
| 25 | Logik |
| 26, 27, 28 | Funktionsblock der Logik |
| 31, 32, 33, 34, 35 | Geber |
| 31-1, 31-2, 31-3, 31-4, 31-5, 31-6, 31-7, 31-8 | Polpaar |

| φ | Drehwinkel |
|---|---|
| $\underline{B}$ | Magnetfeldvektor |
| $B_x$, $B_z$ | Magnetfeldkomponente |
| A, B, C, C', C'', D | Signal |
| x, y, z | Raumrichtung |
| T1, T2 | Periodizität |

**Patentansprüche**

1. Messsystem,

mit einer Magnetfeldsensoranordnung (10), die einen in einem Halbeiterchip integrierten ersten Magnetfeldsensor (11) zur Messung einer ersten Komponente ($B_x$) eines Magnetfeldes ($\underline{B}$) in einer ersten Raumrichtung (x) und einen im Halbeiterchip integrierten zweiten Magnetfeldsensor (12) zur Messung einer zweiten Komponente ($B_z$) des Magnetfeldes ($\underline{B}$) in einer zweiten Raumrichtung (z) und einen Magneten (19) aufweist,
mit einem entlang einer Bahn beweglichen Geber (33, 35) der eine Mehrzahl von Zähnen aufweist,

wobei ein Material der Zähne das Magnetfeld ($\underline{B}$) des Magneten (19) beeinflusst,
wobei die Zähne des Gebers (33) ausgebildet sind, bei einer Bewegung des Gebers (33) entlang der Bahn eine wegabhängige erste Änderung des Magnetfelds ($\underline{B}$) mit einer ersten Periodizität ($T_1$) in der Magnetfeldsensoranordnung (10) zu erzeugen, und

mit einer Auswertungsschaltung (20), an die der erste Magnetfeldsensor (11) und der zweite Magnetfeldsensor (12) angeschlossen sind,
wobei die Auswertungsschaltung (20) eingerichtet ist, zur Erzeugung eines ersten Signals (D) mit der ersten Periodizität ($T_1$) aus einem ersten Messsignal (A) des ersten Magnetfeldsensors (11) und einem zweiten Messsignal (B) des zweiten Magnetfeldsensors (12) entsprechend einer Arcustangens-Funktion arctan (A/B),

- dass die Auswertungsschaltung (20) eingerichtet ist, ein zweites Signal (C) mit der zweiten Periodizität ($T_2$) aus dem ersten Messsignal (A) des ersten Magnetfeldsensors (11) und dem zweiten Messsignal (B) des zweiten Magnetfeldsensors (12) entsprechend einer Betragsfunktion |A|+|B| zu erzeugen, und
- dass die Auswertungsschaltung (20) eine Logik (25) aufweist, die eingerichtet ist, eine Position des Gebers (33, 35) basierend auf dem ersten Signal (D) und dem zweiten Signal (C) zu bestimmen,

**dadurch gekennzeichnet, dass**

die Zähne des einzigen Gebers (33, 35) derart angeordnet sind, dass in Abhängigkeit von der Bewegung des Gebers (33, 35) der Abstand zwischen den Spitzen der Zähne des Gebers (33, 35) und der Magnetfeldsensoranordnung (10) sich verändert und mit Verringerung des Abstands die Länge des Magnetfeldvektors zunimmt, um eine wegabhängige zweite Änderung des Magnetfelds ($\underline{B}$) mit einer zweiten Periodizität ($T_2$) in der Magnetfeldsensoranordnung (10) zu erzeugen, wobei die zweite Periodizität ($T_2$) größer als die erste Periodizität ($T_1$) ist.

2. Messsystem nach Anspruch 1,
**dadurch gekennzeichnet,**

- **dass** eine Periode der zweiten Periodizität ($T_2$) einer Wegstrecke zwischen Endpunkten der Bahn entspricht.

3. Messsystem nach einem der vorhergehenden Ansprüche,
**dadurch gekennzeichnet,**

- **dass** der Geber (33, 35) ausgebildet ist, die zweite Magnetfeldänderung mittels einer Änderung einer Luftspaltbreite zwischen dem Geber (33, 35) und der Magnetfeldsensoranordnung (10) zu erzeugen.

4. Messsystem nach einem der vorhergehenden Ansprüche,
**dadurch gekennzeichnet,**

- **dass** der Geber (33, 35) entlang einer Bahn relativ zur Magnetfeldsensoranordnung (10) linear oder rotatorisch beweglich ist.

5. Messsystem nach einem der vorhergehenden Ansprüche,
   **dadurch gekennzeichnet,**

   - **dass** der Magnet (19) und der Geber (33, 35) entlang einer Verbindungslinie zueinander beabstandet sind und der Halbleiterchip auf der Verbindungslinie zwischen dem Magneten (19) und dem Geber (33, 35) angeordnet ist.

6. Messsystem nach einem der vorhergehenden Ansprüche,
   **dadurch gekennzeichnet,**

   - **dass** die Logik (25) eingerichtet ist, ein Ergebnis der Betragsfunktion ($|A|+|B|$) mit einer Anzahl von Schwellwerten zu vergleichen.

**Claims**

1. Measuring system comprising
   a magnetic field sensor arrangement (10), which comprises a first magnetic field sensor (11), which is integrated in a semiconductor chip, for measuring a first component ($B_x$) of a magnetic field ($\underline{B}$) in a first spatial direction (x), a second magnetic field sensor (12), which is integrated in the semiconductor chip, for measuring a second component ($B_z$) of the magnetic field ($\underline{B}$) in a second spatial direction (z), and a magnet (19),
   a transmitter (33, 35) which is movable along a track and which has a plurality of teeth,

   wherein a material of the teeth influences the magnetic field ($\underline{B}$) of the magnet (19) and
   wherein the teeth of the transmitter (33) are constructed to produce, on movement of the transmitter (33) along the track, a travel-dependent first change in the magnetic field ($\underline{B}$) at a first periodicity ($T_1$) in the magnetic field sensor arrangement (10),

   and an evaluating circuit (20) with which the first magnetic field sensor (11) and the second magnetic field sensor (12) are connected,

   wherein the evaluating circuit (20) is arranged to generate a first signal (D) at the first periodicity ($T_1$) from a first measurement signal (A) of the first magnetic field sensor (11) and a second measurement signal (B) of the second magnetic field sensor (12) in correspondence with an arc-tangent function arctan (AB),
   the evaluating circuit (20) being arranged to generate a second signal (C) at the second periodicity ($T_2$) from the first measurement signal (A) of the first magnetic field sensor (11) and the second measurement signal (B) of the second magnetic field sensor (12) in correspondence with a values function $|A| + |B|$ and
   the evaluating circuit (20) comprising logic means (25) arranged to determine a position of the transmitter (33, 35) based on the first signal (D) and the second signal (C),

   **characterised in that**
   the teeth of the single transmitter (33, 35) are so arranged that the spacing between the tips of the teeth of the transmitter (33, 35) and the magnetic field sensor arrangement (10) changes in dependence on the movement of the transmitter (33, 35) and, with reduction of the spacing, the length of the magnetic field vector increases so as to produce a travel-dependent second change of the magnetic field ($\underline{B}$) at a second periodicity ($T_2$) in the magnetic field sensor arrangement (10), wherein the second periodicity ($T_2$) is greater than the first periodicity ($T_1$).

2. Measuring system according to claim 1, **characterised in that** a period of the second periodicity ($T_2$) corresponds with a travel path between end points of the track.

3. Measuring system according to one of the preceding claims, **characterised in that** the transmitter (33, 35) is constructed to produce the second magnetic field change by means of a change in an air gap width between the transmitter (33, 35) and the magnetic field sensor arrangement (10).

4. Measuring system according to any one of the preceding claims, **characterised in that** the transmitter (33, 35) is linearly or rotationally movable along a track relative to the magnetic field sensor arrangement (10).

5.  Measuring system according to any one of the preceding claims, **characterised in that** the magnet (19) and the transmitter (33, 35) are spaced apart along a connecting line and the semiconductor chip is arranged on the connecting line between the magnet (19) and the transmitter (33, 35).

6.  Measuring system according to any one of the preceding claims, **characterised in that** the logic means (25) is arranged to compare a result of the values function (|A| + |B|) with a number of threshold values.


**Revendications**

1.  Système de mesure,
    avec un dispositif de détecteurs de champ magnétique (10) qui présente un premier détecteur de champ magnétique (11) intégré dans une puce à semi-conducteur pour la mesure d'une première composante (Bx) d'un champ magnétique (B) dans une première direction spatiale (x) et un deuxième détecteur de champ magnétique (12) intégré dans la puce à semi-conducteur pour la mesure d'une deuxième composante (Bz) du champ magnétique (B) dans une deuxième direction spatiale (z) et un aimant (19),
    avec un capteur (33, 35) mobile le long d'un chemin qui présente une multiplicité de dents,
    dans lequel un matériau des dents influence le champ magnétique (B) de l'aimant (19),
    dans lequel les dents du capteur (33) sont configurées pour produire, lors d'un mouvement du capteur (33) le long du chemin, une première variation du champ magnétique (B) dépendant de la course avec une première périodicité ($T1$) dans le dispositif de détecteurs de champ magnétique (10), et
    avec un circuit d'exploitation (20), auquel le premier détecteur de champ magnétique (11) et le deuxième détecteur de champ magnétique (12) sont raccordés,
    dans lequel le circuit d'exploitation (20) est conçu pour la production d'un premier signal (D) avec la première périodicité ($T1$) à partir d'un premier signal de mesure (A) du premier détecteur de champ magnétique (11) et d'un deuxième signal de mesure (B) du deuxième détecteur de champ magnétique (12) correspondant à une fonction arctangente arctan (A/B),
    dans lequel le circuit d'exploitation (20) est conçu pour produire un deuxième signal (C) avec une deuxième périodicité ($T_2$) à partir du premier signal de mesure (A) du premier détecteur de champ magnétique (11) et du deuxième signal de mesure (B) du deuxième détecteur de champ magnétique (12) correspondant à une fonction de valeur |A| + |B|, et
    dans lequel le circuit d'exploitation (20) présente une logique (25), qui est conçue pour déterminer une position du capteur (33, 35) sur la base du premier signal (D) et du deuxième signal (C),
    **caractérisé en ce que**
    les dents du capteur unique (33, 35) sont disposées de telle manière qu'en fonction du mouvement du capteur (33, 35), la distance entre les pointes des dents du capteur (33, 35) et le dispositif de détecteurs de champ magnétique (10) varie et que la longueur du vecteur de champ magnétique augmente avec la diminution de la distance afin de produire une deuxième variation du champ magnétique (B) dépendant de la course avec une deuxième périodicité ($T_2$) dans le dispositif de détecteurs de champ magnétique (10), dans lequel la deuxième périodicité (T2) est plus élevée que la première périodicité ($T_1$).

2.  Système de mesure selon la revendication 1, **caractérisé en ce qu'**une période de la deuxième périodicité ($T_2$) correspond à une section de course entre des points d'extrémité du chemin.

3.  Système de mesure selon l'une quelconque des revendications précédentes, **caractérisé en ce que** le capteur (33, 35) est configuré pour produire la deuxième variation du champ magnétique au moyen d'une variation d'une largeur d'entrefer entre le capteur (33, 35) et le dispositif de détecteurs de champ magnétique (10).

4.  Système de mesure selon l'une quelconque des revendications précédentes, **caractérisé en ce que** le capteur (33, 35) est mobile de façon linéaire ou rotative le long d'un chemin par rapport au dispositif de détecteurs de champ magnétique (10).

5.  Système de mesure selon l'une quelconque des revendications précédentes, **caractérisé en ce que** l'aimant (19) et le capteur (33, 35) sont espacés l'un de l'autre le long d'une ligne de liaison et la puce à semi-conducteur est disposée sur la ligne de liaison entre l'aimant (19) et le capteur (33, 35).

6.  Système de mesure selon l'une quelconque des revendications précédentes, **caractérisé en ce que** la logique (25) est conçue pour comparer un résultat de la fonction de valeur (|A| + |B|) avec un certain nombre de valeurs de seuil.

Fig. 1 (Stand der Technik)

Fig. 2

Fig. 3

Fig. 4

Fig. 5

Fig. 6

Fig. 7

Fig. 8

Fig. 9

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2354769 A1
- DE 102008059401 A1
- DE 102010019508 A1
- US 2012095712 A1
- DE 102007022196 A1

- DE 102010002292 A1
- EP 1477772 A1
- EP 1111392 A1
- EP 1503182 B1

**In der Beschreibung aufgeführte Nicht-Patentliteratur**

- **J. QUASDORF.** *ELEKTRONIK PRAXIS,* 17. September 2008, 22